# EUROPEAN PATENT APPLICATION

(11) **EP 3 299 889 A1**
(43) Date of publication of application: **28.03.2018**
(21) Application number: 16190865.2
(22) Date of filing: 27.09.2016
(51) Int. Cl.: G03F 7/16, B05D 1/18, H01L 21/687

(54) **A SUBSTRATE, A SUBSTRATE HOLDER, A SUBSTRATE COATING APPARATUS, A METHOD FOR COATING THE SUBSTRATE AND A METHOD FOR REMOVING THE COATING**

(71) Applicant: ASML Netherlands B.V., 5500 AH Veldhoven (NL)
(72) Inventor: ACHANTA, Satish, 5500 AH Veldhoven (NL); WELTERS, Wilhelmus, Jacobus, Johannes, 5500 AH Veldhoven (NL); SOETHOUDT, Abraham, Alexander, 5500 AH Veldhoven (NL); KAMMINGA, Jelmer, Mattheüs, 5500 AH Veldhoven (NL); LIEDECKE, Christian, 5500 AH Veldhoven (NL)
(74) Representative: Peters, John Antoine

(57) **Abstract**

The present invention relates to a substrate (100), a substrate holder (200), a substrate coating apparatus (800. 801), a method for coating the substrate (100) and a method for removing the coating (102. Clamping of a substrate (100) often results in substrate deformation. This is caused by friction forces (104) between the substrate (100) and the substrate holder (200). These forces (104) result in significant stress components causing translation of features on the substrate. The friction forces need however to be sufficiently large to keep the substrate firmly attached to the substrate holder during the lithographic process. This dual character of the friction forces poses a problem. This problem is solved by applying a monomolecular layer (102) to the backside (101) of the substrate or a clamp surface (201) of the substrate holder (200). The friction force between the substrate backside and the substrate is small when the substrate does not experience full clamping force (210). This allows a stress-free relaxation of the substrate (100). After loading the substrate (100) on the substrate holder (200) full clamping force (210) is exerted in order to fix the substrate with respect to the substrate holder. The clamping force causes local removal of the monomolecular layer (102), resulting in a direct contact (205) between the substrate backside (101) and the clamp surface (201) of the substrate holder. This direct contact results in a strong increase of the friction force between the substrate (100) and the substrate holder (200).

## Description

### Field

The present invention relates to a substrate, a substrate holder, a substrate coating apparatus, a method for coating the substrate and a method for removing the coating.

### Background

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g. comprising part of, one, or several dies) on a substrate (e.g. a silicon wafer). Transfer of the pattern is typically via imaging onto a layer of radiation-sensitive material (resist) provided on the substrate. In general, a single substrate will contain a network of adjacent target portions that are successively patterned. Known lithographic apparatus include so-called steppers, in which each target portion is irradiated by exposing an entire pattern onto the target portion at one time, and so-called scanners, in which each target portion is irradiated by scanning the pattern through a radiation beam in a given direction (the "scanning"-direction) while synchronously scanning the substrate parallel or anti-parallel to this direction. It is also possible to transfer the pattern from the patterning device to the substrate by imprinting the pattern onto the substrate.

It is desirable that when a substrate is first loaded onto a substrate holder in preparation for exposure it is held freely so that any stresses can be released. During the loading process, the substrate is supported by so-called e-pins which hold it at three positions Therefore, the weight of the substrate causes it to distort and it is desirable that this distortion be released before exposures. On the other hand, it is desirable that the substrate be held very firmly during exposure. There are two reasons for this. Firstly, the substrate is subjected to very large accelerations during an exposure sequence in order to achieve a high throughput and must not move on the substrate holder. Secondly, the substrate absorbs energy from the projection beam during exposure and therefore heats up locally. Such local heating can cause thermal expansion causing slip between substrate and burls leading to overlay errors. By holding the substrate firmly to the substrate holder such distortion can be resisted.

A substrate holder conventionally has a plurality of burls to support the substrate. The total area of the burls that contacts the substrate is small compared to the total area of a substrate.

The substrate is conventionally clamped to the substrate holder during exposures. Two clamping techniques are commonly used. In vacuum-clamping a pressure differential across the substrate is established, e.g., by connecting the space between the substrate holder and the substrate to an under-pressure that is lower than a higher pressure above the substrate. The pressure difference gives rise to a force holding the substrate to the substrate holder. In electrostatic clamping, electrostatic forces are used to exert a force between the substrate and the substrate holder. Several different arrangements are known to achieve this. In one arrangement a first electrode is provided on the lower surface of the substrate and a second electrode on the upper surface (also referred to as the clamp surface) of the substrate holder. A potential difference is established between the first and second electrodes. In another arrangement two semi-circular electrodes are provided on the substrate holder and a conductive layer is provided on the substrate. A potential difference is applied between the two semi-circular electrodes so that the two semi-circular electrodes and the conductive layer on the substrate act like two capacitors in series.

It is commonly observed that clamping of a flat or non-flat (curved) substrate results in substrate deformation. This is caused by friction forces, occurring between the substrate and the substrate holder, preventing a stress-free flattening of the substrate when it is placed on the clamp surface of the substrate holder. These forces are directed within the plane of the substrate and result in significant compressive and/or tensile stress components. By elastic deformation these stress components cause translation of product features or markers on the substrate which result in significantly worse alignment and/or overlay performance of the lithographic apparatus. The friction forces need however to be sufficiently large to keep the substrate firmly attached to the substrate holder during the lithographic process. This dual character of the friction forces poses a problem when aiming for lithographic processing of substrates that need to remain free of stress components and positioned stably with respect to the substrate holder.

### SUMMARY

The problem can be solved by controlling the friction forces between the substrate and the substrate holder; a low friction force must be present during loading of the substrate to the substrate holder and a higher friction force must be present when the substrate is clamped to the substrate holder while being subject to a lithographic process.

According to an embodiment, there is provided a substrate for a lithographic process, the substrate comprising a backside configured to be clamped to a substrate holder of an apparatus, the backside is at least partially provided with a monomolecular layer configured to reduce a friction coefficient of the backside.

According to another embodiment, there is provided a substrate holder for a lithographic apparatus, the substrate holder comprising a clamp surface configured to clamp a substrate, the clamp surface is at least partially provided with a monomolecular layer configured to reduce a friction coefficient of the clamp surface.

According to another embodiment, there is provided a substrate coating apparatus, the substrate coating apparatus comprising a vapor supply system providing a vapor adjacent to the backside of the substrate, the vapor creating a monomolecular layer on at least a part of the backside of the substrate.

According to another embodiment, there is provided a method for creating a monomolecular layer on a substrate, the method comprising bringing a vapor adjacent to the substrate.

An effect of applying the monomolecular layer to the backside of the substrate is that the friction forces between the substrate backside and the substrate holder become small when the substrate is loaded on the substrate holder; i.e., when the substrate does not experience full clamping force. This allows a stress-free relaxation of the substrate. After loading the substrate on the substrate holder full clamping force is exerted in order to fix the substrate with respect to the substrate holder. The clamping force causes local removal of the monomolecular layer, resulting in a direct contact between the substrate backside and the clamp surface of the substrate holder. This direct contact results in a strong increase of the friction force between the substrate and the substrate holder. The increased friction force is beneficial for positional stability of the substrate with respect to the substrate holder during lithographic processing.

According to another embodiment, there is provided a method for removing a monomolecular layer from a substrate, the method comprising a step of exposing the substrate to a light source.

According to another embodiment, there is provided a lithographic apparatus comprising a substrate, the substrate comprising a backside configured to be clamped to a substrate holder of the lithographic apparatus, the backside is at least partially provided with a monomolecular layer configured to reduce a friction coefficient of the backside.

According to another embodiment, there is provided a metrology apparatus comprising a substrate, the substrate comprising a backside configured to be clamped to a substrate holder of the metrology apparatus, the backside is at least partially provided with a monomolecular layer configured to reduce a friction coefficient of the backside.

According to another embodiment, there is provided a lithographic apparatus comprising a substrate holder, the substrate holder comprising a clamp surface configured to clamp a substrate, the clamp surface is at least partially provided with a monomolecular layer configured to reduce a friction coefficient of the clamp surface.

According to another embodiment, there is provided a metrology apparatus comprising a substrate holder, the substrate holder comprising a clamp surface configured to clamp a substrate, the clamp surface is at least partially provided with a monomolecular layer configured to reduce a friction coefficient of the clamp surface.

According to another embodiment, there is provided a lithographic apparatus comprising a substrate coating apparatus, the substrate coating apparatus comprising a vapor supply system providing a vapor adjacent to the backside of the substrate, the vapor creating a monomolecular layer on at least a part of the backside of the substrate.

According to another embodiment, there is provided a metrology apparatus comprising a substrate coating apparatus, the substrate coating apparatus comprising a vapor supply system providing a vapor adjacent the backside of the substrate, the vapor creating a monomolecular layer on at least a part of the backside of the substrate.

According to another embodiment, there is provided a spin coating apparatus comprising a substrate coating apparatus, the substrate coating apparatus comprising a vapor supply system providing a vapor adjacent to the backside of the substrate, the vapor creating a monomolecular layer on at least a part of the backside of the substrate.

### Brief Description of the Drawings

Embodiments of the invention will now be described, by way of example only, with reference to the accompanying schematic drawings in which corresponding reference symbols indicate corresponding parts, and in which:
Figure 1 schematically depicts a lithographic apparatus according to an embodiment;
Figure 2 schematically depicts a substrate resting on a substrate holder;
Figure 3 schematically depicts the orientation of molecules within a mono-molecular layer according to an embodiment;
Figure 4 schematically depicts a substrate according to an embodiment as positioned on a substrate holder;
Figure 5 depicts a substrate with a partially coverage of a monomolecular layer according to an embodiment;
Figure 6 shows measurement results demonstrating an improvement in performance achieved by implementing an embodiment of the invention.
Figure 7 depicts a planar substrate holder according to an embodiment;
Figure 8 depicts a substrate holder comprising burls according to an embodiment;
Figure 9 depicts a first substrate coating apparatus according to an embodiment;
Figure 10 depicts a second substrate coating apparatus according to an embodiment;;
Figure 11 depicts a spin coat apparatus according to an embodiment;
Figure 12 depicts a coating apparatus for coating multiple substrates simultaneously according to an embodiment;
Figure 13 depicts a method for removing the monomolecular layer according to an embodiment.

### Detailed Description

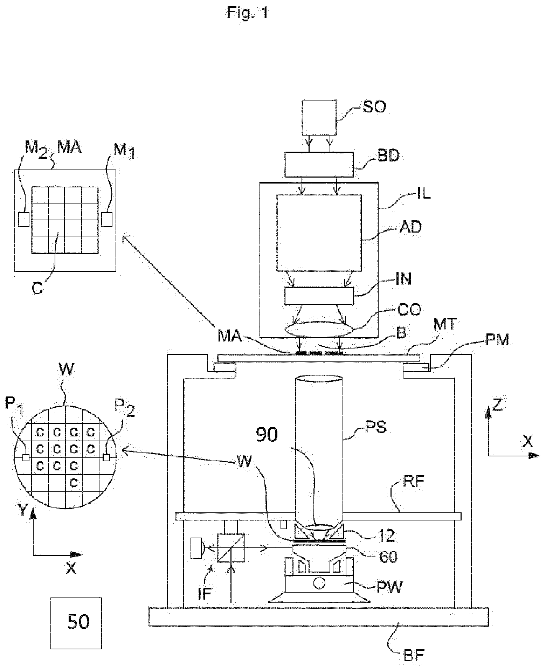

Figure 1 schematically depicts a lithographic apparatus of an embodiment of the invention. The apparatus comprises:
- an illumination system (illuminator) IL configured to condition a radiation beam B (e.g. UV radiation or DUV radiation);
- a support structure (e.g. a mask table) MT constructed to support a patterning device (e.g. a mask) MA and connected to a first positioner PM configured to accurately position the patterning device MA in accordance with certain parameters;
- a support table, e.g. a sensor table to support one or more sensors or a substrate support apparatus 60 constructed to hold a substrate (e.g. a resist-coated production substrate) W, connected to a second positioner PW configured to accurately position the surface of the table, for example of a substrate W, in accordance with certain parameters; and
- a projection system (e.g. a refractive projection lens system) PS configured to project a pattern imparted to the radiation beam B by patterning device MA onto a target portion C (e.g. comprising part of, one, or more dies) of the substrate W.

The illumination system IL may include various types of optical components, such as refractive, reflective, magnetic, electromagnetic, electrostatic or other types of optical components, or any combination thereof, for directing, shaping, or controlling radiation.

The support structure MT holds the patterning device MA. It holds the patterning device MA in a manner that depends on the orientation of the patterning device MA, the design of the lithographic apparatus, and other conditions, such as for example whether or not the patterning device MA is held in a vacuum environment. The support structure MT can use mechanical, vacuum, electrostatic or other clamping techniques to hold the patterning device MA. The support structure MT may be a frame or a table, for example, which may be fixed or movable as required. The support structure MT may ensure that the patterning device MA is at a desired position, for example with respect to the projection system PS. Any use of the terms "reticle" or "mask" herein may be considered synonymous with the more general term "patterning device."

The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

The patterning device MA may be transmissive or reflective. Examples of patterning devices include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions. The tilted mirrors impart a pattern in a radiation beam which is reflected by the mirror matrix.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system".

As here depicted, the lithographic apparatus is of a transmissive type (e.g. employing a transmissive mask). Alternatively, the lithographic apparatus may be of a reflective type (e.g. employing a programmable mirror array of a type as referred to above, or employing a reflective mask).

The lithographic apparatus may be of a type having two or more tables (or stage(s) or support(s)), e.g., two or more substrate tables or a combination of one or more substrate tables and one or more sensor or measurement tables. In such "multiple stage" machines the multiple tables may be used in parallel, or preparatory steps may be carried out on one or more tables while one or more other tables are being used for exposure. The lithographic apparatus may have two or more patterning device tables (or stage(s) or support(s)) which may be used in parallel in a similar manner to substrate, sensor and measurement tables. The lithographic apparatus may be of a type that has a measurement station, at which there are various sensors for characterizing a production substrate prior to exposure and an exposure station, at which the exposures are commanded out.

The lithographic apparatus is of a type wherein at least a portion of the substrate W may be covered by a immersion liquid 10 having a relatively high refractive index, e.g. water such as ultra pure water (UPW), so as to fill an immersion space 11 between the projection system PS and the substrate W. An immersion liquid 10 may also be applied to other spaces in the lithography apparatus, for example, between the patterning device MA and the projection system PS. Immersion techniques can be used to increase the numerical aperture of projection systems. The term "immersion" as used herein does not mean that a structure, such as a substrate W, must be submerged in immersion liquid 10; rather "immersion" only means that an immersion liquid 10 is located between the projection system PS and the substrate W during exposure. The path of the patterned radiation beam B from the projection system PS to the substrate W is entirely through immersion liquid 10.

Referring to Figure 1, the illuminator IL receives a radiation beam from a radiation source SO. The source SO and the lithographic apparatus may be separate entities, for example when the source SO is an excimer laser. In such cases, the source SO is not considered to form part of the lithographic apparatus and the radiation beam is passed from the source SO to the illuminator IL with the aid of a beam delivery system BD comprising, for example, suitable directing mirrors and/or a beam expander. In other cases the source SO may be an integral part of the lithographic apparatus, for example when the source SO is a mercury lamp. The source SO and the illuminator IL, together with the beam delivery system BD if required, may be referred to as a radiation system.

The illuminator IL may comprise an adjuster AD for adjusting the angular intensity distribution of the radiation beam B. Generally, at least the outer and/or inner radial extent (commonly referred to as σ-outer and σ-inner, respectively) of the intensity distribution in a pupil plane of the illuminator IL can be adjusted. In addition, the illuminator IL may comprise various other components, such as an integrator IN and a condenser CO. The illuminator IL may be used to condition the radiation beam B to have a desired uniformity and intensity distribution in its cross-section. Similar to the source SO, the illuminator IL may or may not be considered to form part of the lithographic apparatus. For example, the illuminator IL may be an integral part of the lithographic apparatus or may be a separate entity from the lithographic apparatus. In the latter case, the lithographic apparatus may be configured to allow the illuminator IL to be mounted thereon. Optionally, the illuminator IL is detachable and may be separately provided (for example, by the lithographic apparatus manufacturer or another supplier).

The radiation beam B is incident on the patterning device (e.g., mask) MA, which is held on the support structure (e.g., mask table) MT, and is patterned by the patterning device MA. Having traversed the patterning device MA, the radiation beam B passes through the projection system PS, which focuses the beam onto a target portion C of the substrate W. With the aid of the second positioner PW and position sensor IF (e.g. an interferometric device, linear encoder or capacitive sensor), the substrate support apparatus 60 can be moved accurately, e.g. so as to position different target portions C in the path of the radiation beam B.

Similarly, the first positioner PM and another position sensor (which is not explicitly depicted in Figure 1) can be used to accurately position the patterning device MA with respect to the path of the radiation beam B, e.g. after mechanical retrieval from a mask library, or during a scan. In general, movement of the support structure MT may be realized with the aid of a long-stroke module (coarse positioning) and a short-stroke module (fine positioning), which form part of the first positioner PM. Similarly, movement of the substrate support apparatus 60 may be realized using a long-stroke module and a short-stroke module, which form part of the second positioner PW.

In the case of a stepper (as opposed to a scanner) the support structure MT may be connected to a short-stroke actuator only, or may be fixed. Patterning device MA and substrate W may be aligned using patterning device alignment marks M1, M2 and substrate alignment marks P1, P2. Although the substrate alignment marks P1, P2 as illustrated occupy dedicated target portions, they may be located in spaces between target portions C (these are known as scribe-lane alignment marks). Similarly, in situations in which more than one die is provided on the patterning device MA, the patterning device alignment marks M1, M2 may be located between the dies.

The depicted apparatus could be used in at least one of the following modes:
1. In step mode, the support structure MT and the substrate support apparatus 60 are kept essentially stationary, while an entire pattern imparted to the radiation beam B is projected onto a target portion C at one time (i.e. a single static exposure). The substrate support apparatus 60 is then shifted in the X and/or Y direction so that a different target portion C can be exposed. In step mode, the maximum size of the exposure field limits the size of the target portion C imaged in a single static exposure.
2. In scan mode, the support structure MT and the substrate support apparatus 60 are scanned synchronously while a pattern imparted to the radiation beam B is projected onto a target portion C (i.e. a single dynamic exposure). The velocity and direction of the substrate support apparatus 60 relative to the support structure MT may be determined by the (de-)magnification and image reversal characteristics of the projection system PS. In scan mode, the maximum size of the exposure field limits the width (in the non-scanning direction) of the target portion C in a single dynamic exposure, whereas the length of the scanning motion (and size of the exposure field) determines the height (in the scanning direction) of the target portion C.
3. In another mode, the support structure MT is kept essentially stationary holding a programmable patterning device, and the substrate support apparatus 60 is moved or scanned while a pattern imparted to the radiation beam B is projected onto a target portion C. In this mode, generally a pulsed radiation source is employed and the programmable patterning device is updated as required after each movement of the substrate support apparatus 60 or in between successive radiation pulses during a scan. This mode of operation can be readily applied to maskless lithography that utilizes a programmable patterning device, such as a programmable mirror array of a type as referred to above.

Combinations and/or variations on the above described modes of use or entirely different modes of use may also be employed.

A controller 50 controls the overall operations of the lithographic apparatus and in particular performs an operation process described further below. Controller 50 can be embodied as a suitably-programmed general purpose computer comprising a central processing unit, volatile and non-volatile storage means, one or more input and output devices such as a keyboard and screen, one or more network connections and one or more interfaces to the various parts of the lithographic apparatus. It will be appreciated that a one-to-one relationship between controlling computer and lithographic apparatus is not necessary. One computer can control multiple lithographic apparatuses. Multiple networked computers can be used to control one lithographic apparatus. The controller 50 may also be configured to control one or more associated process devices and substrate handling devices in a lithocell or cluster of which the lithographic apparatus forms a part. The controller 50 can also be configured to be subordinate to a supervisory control system of a lithocell or cluster and/or an overall control system of a fab.

Arrangements for providing immersion liquid between a final optical element of the projection system PS and the substrate W can be classed into three general categories. These are the bath type arrangement, the so-called localized immersion systems and the all-wet immersion systems. An embodiment of the present invention relates particularly to the localized immersion systems.

In an arrangement which has been proposed for a localized immersion system a liquid confinement structure 12 extends along at least a part of a boundary of an immersion space 11 between the final optical element 90 of the projection system PS and the facing surface of the stage or table facing the projection system PS. The facing surface of the table is referred to as such because the table is moved during use and is rarely stationary. Generally, the facing surface of the table is a surface of a substrate W, substrate table WT which surrounds the substrate W or both.

The liquid confinement structure 12 at least partly contains immersion liquid 10 in the immersion space 11 between the final optical element of the projection system PS and the substrate W and/or substrate support apparatus 60. The immersion space 11 is at least partly formed by the liquid confinement structure 12 positioned below and surrounding the final optical element of the projection system PS.

### Substrate for a lithographic apparatus

To load a substrate onto the substrate support apparatus 60 for exposures, it is picked up by a substrate handler robot and lowered onto a set of e-pins which project through the substrate holder. The substrate holder is a part of the substrate support apparatus configured to fix the substrate during lithographic processing. The e-pins are actuated so that they can be extended and retracted and may be provided with suction openings at their tips to grip the substrate. They may be three e-pins spaced around the center of the substrate holder. Once the substrate has settled on the e-pins, the e-pins are retracted so that the substrate is supported by the substrate holder. While the substrate is being held by the e-pins, its own weight will cause it to distort, e.g. becoming convex when viewed from above. As the substrate is lowered onto the substrate holder it will contact in some places, e.g. near the edge, before other places, e.g. near the center, and friction between the substrate holder and the lower surface of the substrate may prevent the substrate fully relaxing into a flat unstressed state. Although the curvature of the substrate when supported on the e-pins is small - due to the rigidity of the substrate - and some relaxation does occur when the substrate is on the substrate holder, a residual curvature can nonetheless be sufficient to cause undesirable overlay errors. In addition to the residual curvature of the substrate caused by being held by the e-pins, the substrate may be curved due to processing. For example during manufacturing of 3D NAND structures the substrate will be subject to deposition of various layers. Those layers may be applied at high temperatures, implying that stress components will build up during a cooling down phase of the substrate (in general the substrate and the deposited layers will not have identical thermal expansion coefficients). These stress components may lead to a substantial curvature or deformation of the substrate. Well known deformation geometries resemble a bowl or an umbrella shape of the substrate. Also more complex deformation shapes may occur; for example a saddle shape.

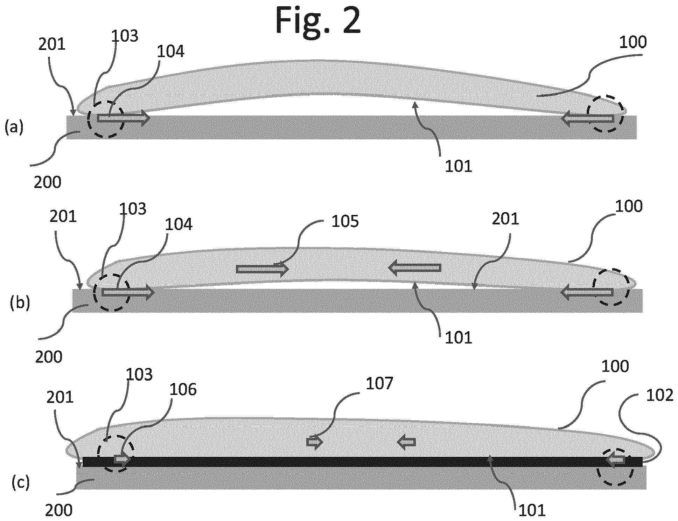

Figure 2a schematically depicts a curved substrate 100 when it has been just lowered by the e-pins. The substrate contacts the clamp surface 201 of the substrate holder 200 at locations indicated by the dashed circle 103. At the locations 103 a friction force 104 is exerted on the substrate 100. The friction force 104 counteracts relaxation of the substrate to a state where a closer contact between the substrate backside 101 and the clamp surface 201 is achieved. Figure 2b schematically depicts the substrate after relaxation. The substrate is less deformed and in closer proximity to the substrate holder clamp surface than the initial phase when the e-pins were just to the clamp surface 201. The friction force 104 does however remain and prevents optimal relaxation of the substrate. The friction force induces internal stress components 105 (these may be tensile or compressive stress components). These stress components may have a considerable impact on pattern position accuracy (overlay errors).

Figure 2c schematically depicts an embodiment of the invention; the backside 101 of a substrate 100 is coated with a monomolecular layer 102. The monomolecular layer consist of a material demonstrating a low friction coefficient 'f' (f << 0.1) when brought in contact with a solid material, like a material from which a substrate holder surface is constructed (for example: ceramics, crystals, glasses, metals). The monomolecular layer decreases the friction force 104 between the substrate backside and the clamp surface 201 of the substrate holder to a smaller friction force 106. The induced stress components are proportional to the friction forces and as a result the stress component 105 is reduced to a smaller stress component 107 (the length of the arrow indicates the magnitude of the force / stress component). The reduction in stress components causes a significant decrease of positional shifts of patterns present on the substrate.

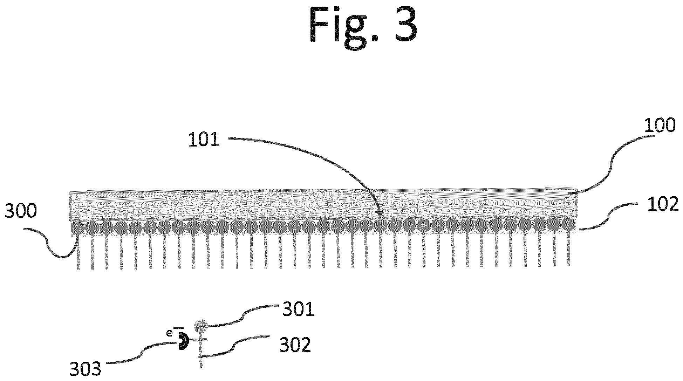

Figure 3 schematically depicts how the molecules within the monomolecular layer are organized. The monomolecular layer 102 is typically a self-assembled monomer (SAM) having low friction coefficient characteristics. Friction characteristics of SAM coated substrates are well known (Singh, Arvind R. et al, "Friction characteristics of self-assembled monolayers coated on Si-Wafer by chemical vapour deposition at nano/micro scale", Proceedings of WTC2005 World Tribology Cougress III September 12-16, 2005, Washington, D. C., USA*).* In addition Lessel et al. ("Self-assembled silane monolayers: A step-by-step high speed recipe for high-quality, low energy surfaces", ArXiv:1212.0998 [cond-mat.mtrl-sci]) mention that providing a silicon substrate with a SAM is a known procedure in order to improve lubrication characteristics of MEMs devices and enhance operation of microfluidic devices. In the current and following embodiments the monomolecular layer is only applied to a backside of a substrate, the substrate is clamped to a substrate holder and the substrate is subject to a lithographic process. The molecules may be based on or comprise silane or siloxane compounds (see also: Kim, Gyu Man et al., "Surface Modification With Self-Assembled Monolayers for Nanoscale Replication of Photoplastic MEMS", Journal of microelectromechanical systems, Vol. 11, No. 3, June 2002.). The molecules 300 of the monomolecular layer comprise a polar head 301 and a non-polar tail 302. The polar heads bind to the substrate such that a two-dimensional network of molecules is formed; the molecules are oriented as a monomolecular layer. The non-polar tails 302 face the substrate holder. The weak binding between the non-polar tails and the substrate holder (typically formed of a crystalline or glass material) results in having a low friction coefficient between the substrate and the substrate holder.

Apart from low friction characteristics the monomolecular layer 102 may also (i) provide hydrophobic properties to the substrate backside known to be beneficial for water management. This is caused by the water repelling properties of the non-polar tails 302 of the molecules 300. In addition a conductive group 303 may be added to the molecules 300 to provide (ii) anti-static properties to the substrate 100. The presence of the monomolecular layer may further (iii) prevent adhesion of particles to the substrate backside. These three additional properties all reduce the likelihood of particles between the substrate backside 101 and the substrate holder surface 201, limiting issues due to contamination of the substrate holder. The hydrophobic property of the monomolecular layer is particularly useful when the substrate is processed in an immersion lithography tool. The water repellent substrate backside prevents the immersion liquid (water) to accumulate on the substrate holder surface.

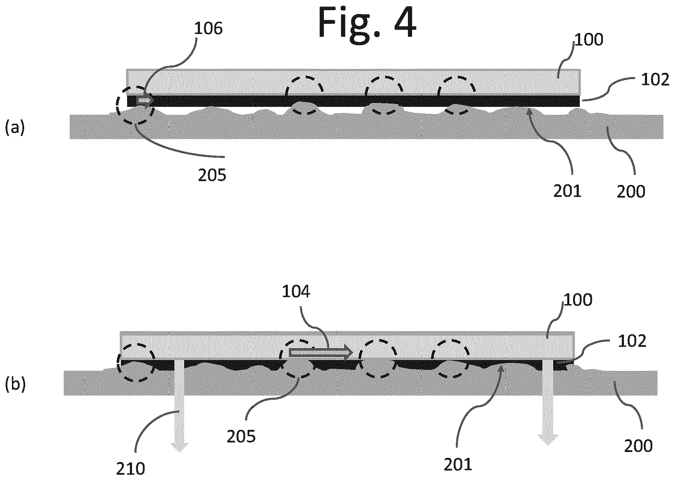

Figure 4a depicts, like figure 2c, a substrate provided with a monomolecular layer positioned on a substrate holder. Figure 4a additionally visualizes a clamp surface 201 of the substrate holder which is rough compared to a typically smooth backside 101 of a substrate 100. The dashed circles 205 are emphasizing the actual contact locations between the monomolecular layer 102 on the substrate backside 101 and the clamp surface 201 of the substrate holder. The contact area between the substrate and the substrate holder is very small; there is only direct contact between the monomolecular layer on the substrate backside and the substrate clamp surface 201at positions 205. At each contact position 205 there is a monomolecular layer 102 between the substrate backside 101 and the substrate holder clamp surface 201 resulting in a low friction force 106 between the substrate and the substrate holder. So far it has been assumed that the substrate is positioned on the substrate holder in an unclamped state; apart from friction and friction induced stress no other forces are exerted on the substrate. During processing steps the substrate is transported and a clamping force needs to be exerted on the substrate in order to keep the substrate in a fixed position with respect to the substrate holder. A large friction force is in this situation beneficial in order to prevent undesired positional changes of the substrate as a result of: i) acceleration forces and ii) thermal expansion of the substrate due to processing (for example due to absorbed energy from the radiation beam B). Thus there are conflicting requirements for the interface between the substrate and the substrate holder: it must be low friction to allow the substrate to fully relax when it is first placed on the substrate holder but higher friction to hold the substrate securely during processing steps.

Figure 4b schematically depicts the substrate when clamped to the substrate holder. This is the situation when the substrate is subject to processing steps, for example a lithographic patterning step. A clamping force 210 (downward arrow) is exerted to the substrate. Above a certain clamping force threshold the pressure exerted on the monomolecular layer will be large enough to locally displace the monomolecular layer. This results in the establishment of direct contact between asperities of the substrate backside 101 and the clamp surface 201 of the substrate holder at the locations 205. The consequence of the direct contact is that the friction force between the substrate 100 and the clamp surface strongly increases; the friction coefficient 'fs' between the substrate material and the material of the clamp surface is typically much larger than the friction coefficient 'f' between the monomolecular layer and the clamp surface (fs>0.1). The friction force increase is depicted in figure 4b by the arrow representing the friction force 104.

Resuming it can be concluded that the monomolecular layer 102 on the substrate backside 101 both achieves having a low friction between the substrate and clamp surface during substrate relaxation while the presence of a clamping force during substrate processing causes displacement of the monomolecular layer resulting in a sufficiently large friction force between the substrate and the clamp surface to ensure positional stability of the substrate.

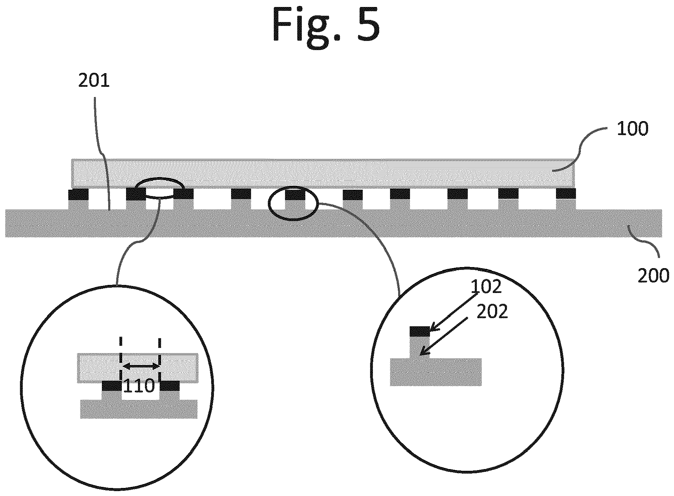

Figure 5 schematically depicts a substrate positioned on a patterned clamp surface 201 of a substrate holder 200. The clamp surface is provided with support structures 202 as indicated by the detail showed in the circle. These support structures may be protrusions, burls, concentric rings or the like. In case of the substrate holder clamp surface 202 being patterned the substrate backside may only be provided with the monomolecular layer outside pre-determined areas 110. Those pre-determined areas are for example areas that are known to not make contact to the surface 201 of a substrate holder given a particular layout of support structures 202. In that case the monomolecular layer could cover less than 90% (high density of support structures), less than 50% (for example when support structures are concentric rings), less than 10% (normal density of support structures) or less than 1% (low density of support structures) of the total surface of the substrate backside 101.

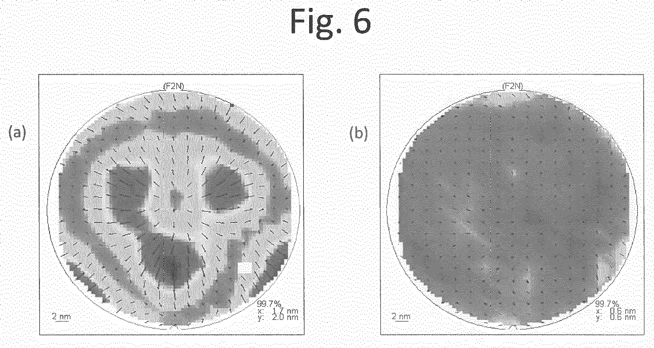

Figure 6a and 6b demonstrate the effect of the presence of the monomolecular layer on a pattern position shift. Figure 6a shows the magnitude of the pattern position shift, measured after clamping of the substrate, due to the presence of stress components being build up in the substrate when no backside coating is provided. It can be seen from the figure (length and directions of the arrows) that at some regions on the substrate the translation of a pattern in the plane of the substrate is as large as 2nm. This is a direct result of the poor relaxation of the curved substrate during loading of the substrate. The effect of a substrate backside coating of a monomolecular layer (in this case with a self-assembled monomer (SAM)) is shown in figure 6b. The improvement of substrate relaxation clearly shows in the observed decrease in pattern position shift; now only a maximum pattern shift of 0.6nm was observed. This improvement may have consequences for the operation of the lithographic apparatus as well; since the loading of a curved substrate does not lead to large pattern position shifts no additional pattern shift measurements are needed to correct for this effect. The time saved by omitting these extra measurements can then be used to expose the substrate; e.g., the throughput of the lithographic apparatus increases.

### Substrate holder

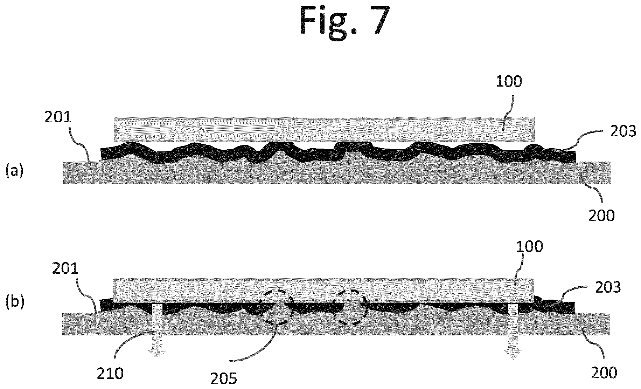

Figure 7a and 7b schematically depict an embodiment relating to an alternative method for achieving an optimal relaxation of the substrate. The clamp surface 201 of the substrate holder 200 is coated with a monomolecular layer 203. The polar heads 301 of the molecules now attach to the clamp surface of the substrate holder while the non-polar tails face the substrate backside. Any friction reducing, hydrophobic, anti-static, particle repelling or particle containing properties of the monomolecular coating are now to be associated with the clamp surface of the substrate holder. The presence of the monomolecular layer again reduces friction when the substrate is loaded on the clamp surface, but not yet clamped, while clamping forces 210 exceeding a threshold (during processing of a substrate) displace the layer and a direct contact between the substrate and substrate holder at locations 205 is established to ensure sufficiently high friction forces will provide positional stability of the substrate during processing of the substrate.

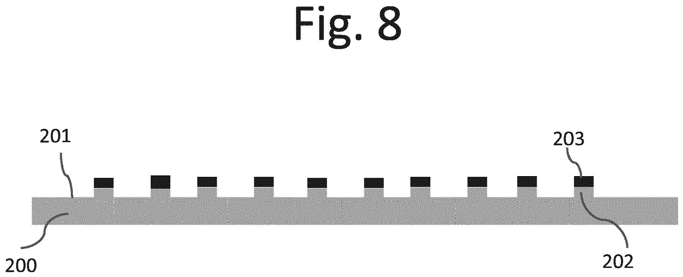

Figure 8 illustrates a substrate holder 200 provided with support structures 202. In principle the entire clamp surface of the substrate holder may be coated with the monomolecular layer 203. However this is not required in case the substrate only makes contact at certain positions on the clamp surface associated with a layout of support structures. It may be sufficient to provide the monomolecular coating only to (a fraction of) the clamp surface 201. Especially when the total surface of the support structures is small compared to the surface of the substrate backside this may reduce the amount of molecules needed for coating.

The disclosed implementations for a substrate 100 and a substrate holder 200 are especially relevant for lithographic apparatus where the allowable pattern position shifts during substrate loading are very small and where substrates are subject to high acceleration forces during process steps (exposure). However the inventions as disclosed herein are not limited to use within such apparatus, but also applicable to substrate holders within eg metrology apparatus (measuring characteristics of features on substrates), coating apparatus (spin coating of wafers) and other substrate processing apparatus (chemical mechanical polishing, etching, ion implant and the like).

### Substrate coating apparatus

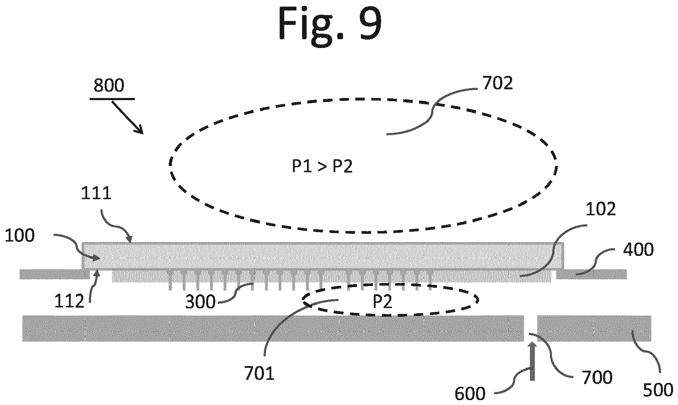

Figure 9 shows an apparatus 800 for providing the monomolecular layer 102 to the substrate backside. The apparatus comprises a bottom plate 500 which together with a substrate backside 101 confines a volume 701. An inlet 700 is provided to the bottom plate to allow a gas 600 to enter the volume 701. The substrate edge region 112 is positioned on a support 400 sealing the volume 701 from the environment 702 surrounding the substrate. Typically the pressure of the gas 'P1' within the environment 702 is chosen to be larger than the pressure of the gas 'P2' within the volume 701. This prevents that the gas 600 leaks into the environment 702 where it may deposit molecules 300 on surfaces other than the required surface 101 (for example the upper side 111 of the substrate which may be coated with a photoresist which should not be contaminated with the molecules 300 in order to guarantee optimal photochemical behavior). By releasing the gas 600 containing molecules 300 (containing a polar head and an non-polar tail) a monomolecular layer attached to the substrate backside 101 is generated. As a carrier gas one or more of the following gases may be used: H2, N2, Clean dry air (CDA), 02, He, Ar, Ne, Xe. The gas flow 600 may, apart from providing the molecules 300 to the substrate backside, also provide thermal conditioning and / or cleaning of the substrate.

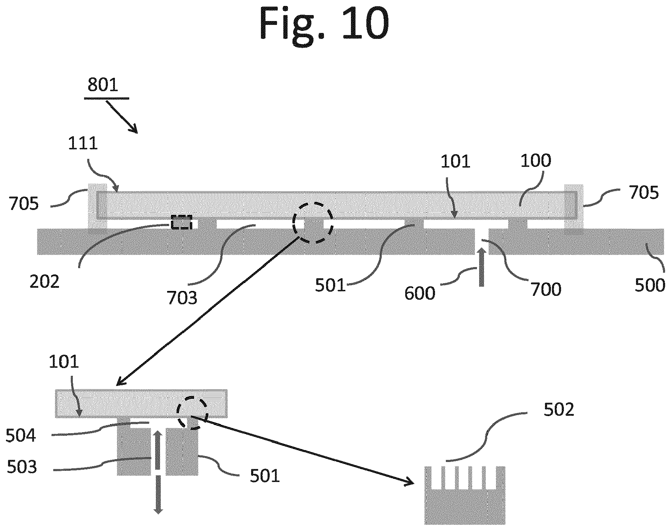

Figure 10 schematically depicts a different embodiment of the apparatus as described in figure 9. The apparatus 801 differs from the apparatus 800 regarding the support of the substrate 100. Instead of supporting the substrate at the edge region 112 the bottom plate 500 is provided with support structures 501 forming a substrate support table. By choosing a particular layout of support structures 501 it is possible to selectively coat the backside of the substrate, for example only provide the monomolecular layer to areas on the substrate backside that contact the support structures 202 of a substrate holder within a lithographic apparatus. This has the advantage that only a minimum required area of a substrate backside will be coated with the monomolecular layer. The positions where the support structures 501 make contact with the substrate backside are then chosen to be different from the positions where the support structures 202 of the substrate holder contact the substrate; this prevents that the monomolecular layer is not present between the substrate backside 101 and the substrate holder support structures 202. In figure 10 it is indicated by the dashed rectangle where the support structure 202 contacts the substrate backside 101 relative to the locations of the support structures 501. To guarantee that the monomolecular layer will be present at all relevant positions (eg where the substrate backside contacts the substrate holder), there should be no area on the substrate backside where positions of support structures 202 and support structures 501 overlap. In analogy to the previous method of bringing the molecules 300 in contact with the substrate backside a gas flow 600 provides via an inlet 700 the molecules into a volume 703. The molecules will not reach the areas on the substrate backside making contact with the support structures 501, only the area of the substrate backside not making contact with the substrate support table will be coated with the monomolecular layer. Additional measures may be taken to prevent molecules 300 from reaching the substrate backside at the positions of the support structures 501. One example is to provide a structure 502 to the surface of the support structures. This structure seals the inner environment 504 from the environment 703 containing the molecules 300. Another implementation is the provision of a channel 503 within the support structure to create a lower or higher pressure (with respect to the pressure of the volume 703) within the space 504 between the support structure surface and the backside of the substrate. Sealing structures 705 are provided to prevent the gas 600 from reaching the substrate upper side 111.

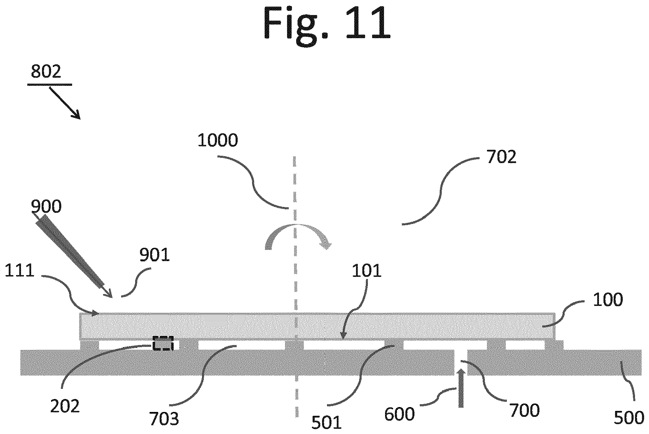

The apparatus 800 or 801 may be implemented as a separate tool, integrated within a semiconductor apparatus (lithographic apparatus, metrology apparatus) or integrated within a (spin) coating apparatus for semiconductor substrates (eg track). An advantage of integrating the tool 800/801 within another apparatus is that the process of providing the monomolecular layer may be executed in parallel with another process. An example is given in figure 11 which schematically depicts a combined front side (spin) coating and substrate backside coating apparatus 802. In this implementation the backside 101 of the substrate surface is provided with a monomolecular layer analogous to the implementation as adopted by apparatus 801. In addition means 900 for coating a front side 111 of a substrate with a photoresist are provided as well. In this example the coating on the substrate front side is based on a spin coating principle (rotation of the substrate around an axis 1000 provides distribution of the coating fluid 901). In principle the process of coating the substrate front side 111 with photoresist and providing a monomolecular layer to the substrate backside 101 may be executed in parallel.

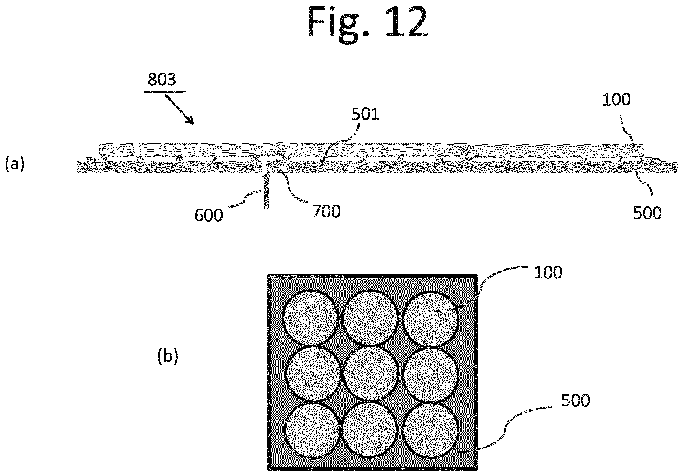

Figure 12a and 12b schematically depict a coating apparatus 803 configured to simultaneously apply a monomolecular layer to multiple substrates. Figure 12a depicts a side view of a multi-substrate coating apparatus. A plurality of substrates 100 are positioned on a substrate table 501. A gas 600 is brought in contact with the substrates and analog to a single substrate case a monomolecular layer is formed on the substrate. Figure 12b is a top view of the apparatus 803; in this example nine substrates can be loaded simultaneously and subsequently provided with a monomolecular layer. The fact that the layer is provided to multiple substrates simultaneously considerably increases the throughput of the coating apparatus. This may be needed when the coating apparatus needs to keep up with a lithographic step (performed by a lithographic apparatus). Current throughput of lithographic apparatus may be as high as 250 substrates per hour, hence the throughput requirement on the coating apparatus needs to match at least this number.

### Coating removal method

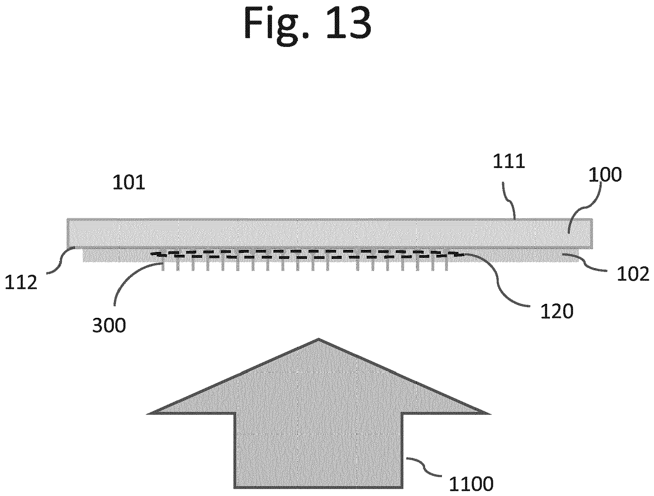

In some cases removal of the monomolecular layer may be necessary. This may be the case when the substrate has to undergo a processing step which is affected by the presence of molecules of the monomolecular layer. Various methods of removing the monomolecular layer are proposed in this document. Figure 13 schematically depicts a method to remove the monomolecular layer from the substrate backside. The method makes use of the exposure of the molecules 300 to a beam of radiation or ions 1100. The objective is to break the bond between the polar heads of the molecules and the non-polar tails (region 120 in figure 13). The beam 1100 may be Ultraviolet (UV) radiation. The high energetic photons of the radiation degrade the molecules and destroy the bond between the polar heads and the non-polar tails. The residual compounds may be removed by a pump system (not shown) in order to prevent that they deposit on the substrate. The exposure with UV light may be done within a lithographic apparatus by making use of the light source which also provides the lithographic patterning of the photosensitive layer on the front side of the substrate.

Although specific reference may be made in this text to the use of lithographic apparatus in the manufacture of ICs, it should be understood that the lithographic apparatus described herein may have other applications, such as the manufacture of integrated optical systems, guidance and detection patterns for magnetic domain memories, flat-panel displays, liquid-crystal displays (LCDs), thin film magnetic heads, etc. The skilled artisan will appreciate that, in the context of such alternative applications, any use of the terms "wafer" or "die" herein may be considered as synonymous with the more general terms "substrate" or "target portion", respectively. The substrate referred to herein may be processed, before or after exposure, in for example a track (a tool that typically applies a layer of resist to a substrate and develops the exposed resist), a metrology tool and/or an inspection tool. Where applicable, the disclosure herein may be applied to such and other substrate processing tools. Further, the substrate may be processed more than once, for example in order to create a multi-layer IC, so that the term substrate used herein may also refer to a substrate that already contains one or multiple processed layers.

The terms "radiation" and "beam" used herein encompass all types of electromagnetic radiation, including ultraviolet (UV) radiation (e.g. having a wavelength of or about 436, 405, 365, 248, 193, 157 or 126 nm). The term "lens", where the context allows, may refer to any one or combination of various types of optical components, including refractive and reflective optical components.

While specific embodiments of the invention have been described above, it will be appreciated that the invention may be practiced otherwise than as described.

Any controllers described herein may each or in combination be operable when the one or more computer programs are read by one or more computer processors located within at least one component of the lithographic apparatus. The controllers may each or in combination have any suitable configuration for receiving, processing, and sending signals. One or more processors are configured to communicate with the at least one of the controllers. For example, each controller may include one or more processors for executing the computer programs that include machine-readable instructions for the methods described above. The controllers may include data storage media for storing such computer programs, and/or hardware to receive such media. So the controller(s) may operate according the machine readable instructions of one or more computer programs.

The descriptions above are intended to be illustrative, not limiting. Thus, it will be apparent to one skilled in the art that modifications may be made to the invention as described without departing from the scope of the claims set out below.

## Claims

1. A substrate for a lithographic process, the substrate comprising a backside configured to be clamped to a substrate holder of an apparatus, the backside is, at least partially, provided with a monomolecular layer configured to reduce a friction coefficient of the backside.

2. A substrate as claimed in claim 1, wherein the friction coefficient of the backside increases when a clamping force exceeds a threshold value.

3. A substrate as claimed in claim 2, wherein the friction coefficient of the backside increases due to a displacement of the monomolecular layer resulting in a direct contact between the backside and the substrate holder.

4. A substrate as claimed in any of the claims 1 to 3, wherein the monomolecular layer is configured to provide hydrophobic properties to the substrate backside.

5. A substrate as claimed in any of claims 1 to 4, wherein the monomolecular layer is configured to provide anti-static properties to the substrate.

6. A substrate as claimed in any of claims 1 to 5, wherein the monomolecular layer is configured to prevent particles from sticking to the substrate backside.

7. A substrate as claimed in any of claims 1 to 6, wherein the monomolecular layer is configured to prevent the substrate backside from releasing particles.

8. A substrate as claimed in any of claims 1 to 7, wherein the molecules of the monomolecular layer possess a polar head and a non-polar tail.

9. A substrate as claimed in any of claims 1 to 8, wherein the monomolecular layer is a self-assembled monomer.

10. A substrate as claimed in any of claims 1 to 9, wherein the monomolecular layer is a silane.

11. A substrate as claimed in any of claims 1 to 9, wherein the monomolecular layer is a siloxane.

12. A substrate as claimed in any of claims 1 to 11, wherein the monomolecular layer only covers an area of the backside which may be in direct contact with the substrate holder.

13. A substrate as claimed in any of claims 1 to 12, wherein the monomolecular layer covers an area less than 90% or less than 50% or less than 10% or less than 1% of the total area of the backside.

14. A substrate holder for an apparatus, the substrate holder comprising a clamp surface configured to clamp a substrate, the clamp surface is, at least partially, provided with a monomolecular layer configured to reduce a friction coefficient of the clamp surface.

15. A substrate holder as claimed in claim 14, wherein the friction coefficient of the clamp surface increases when a clamping force exceeds a threshold value.

16. A substrate holder as claimed in claim 15, wherein the friction coefficient of the clamp surface increases due to a displacement of the monomolecular layer resulting in a direct contact between a substrate backside and the clamp surface.

17. A substrate holder as claimed in any of claims 14 to 16, wherein the monomolecular layer is configured to provide hydrophobic properties to the clamp surface.

18. A substrate holder as claimed in any of claims 14 to 17, wherein the monomolecular layer is configured to provide anti-static properties to the clamp surface.

19. A substrate holder as claimed in any of claims 14 to 18, wherein the monomolecular layer is configured to prevent particles from sticking to the clamp surface.

20. A substrate holder as claimed in any of claims 14 to 19, wherein the monomolecular layer is configured to prevent the clamp surface from releasing particles.

21. A substrate holder as claimed in any of claims 14 to 20, wherein the molecules of the monomolecular layer possess a polar head and a non-polar tail.

22. A substrate holder as claimed in any of claims 14 to 21, wherein the monomolecular layer is a self-assembled monomer.

23. A substrate holder as claimed in any of claims 14 to 22, wherein the monomolecular layer is a silane.

24. A substrate holder as claimed in any of claims 14 to 22, wherein the monomolecular layer is a siloxane.

25. A substrate holder as claimed in any of claims 14 to 24, wherein the clamp surface is configured to support the backside of the substrate at a finite number of positions.

26. A substrate holder as claimed in claim 25, wherein the monomolecular layer only covers an area of the clamp surface which may be in direct contact with the substrate backside.

27. A substrate coating apparatus, the substrate coating apparatus comprising a vapor supply system providing a vapor adjacent to the backside of the substrate, the vapor creating a monomolecular layer on at least a part of the backside of the substrate.

28. A substrate coating apparatus as claimed in claim 27, wherein the substrate coating apparatus further comprises a substrate support table which supports the substrate backside at pre-defined positions.

29. A substrate coating apparatus as claimed in claim 28, wherein the pre-defined positions are different from positions on the backside of the substrate which may be in contact with a substrate holder during a process step.

30. A substrate coating apparatus as claimed in claim 29, wherein the substrate support table is configured to prevent the vapor from reaching the backside of the substrate at the pre-defined positions.

31. A substrate coating apparatus as claimed in any of claims 27 to 30, wherein a sealing structure prevents the vapor from reaching an upper side of the substrate.

32. A substrate coating apparatus as claimed in claim 31, wherein the backside of the substrate is subject to a lower ambient pressure than the upper side of the substrate, contributing to a lower likelihood of the vapor reaching the upper side of the substrate.

33. A substrate coating apparatus as claimed in any of claims 27 to 32, further comprising a gas supply system, directing a gas flow towards the substrate.

34. A substrate coating apparatus as claimed in claim 33, wherein the gas flow carries one of the following gases to the substrate: H2, N2, XCDA, 02, He, Ar, Ne, Xe.

35. A substrate coating apparatus as claimed in claim 33 or 34, wherein the gas flow is mixed with the vapor and is directed to the first surface of the substrate.

36. A substrate coating apparatus as claimed in any of claims 27 to 35, wherein the substrate coating apparatus is integrated within a lithographic apparatus - like wafer handler or track tools?.

37. A substrate coating apparatus as claimed in any of claims 27 to 35, wherein the substrate coating apparatus is integrated within a resist coating apparatus.

38. A substrate coating apparatus as claimed in any of claims 27 to 37, wherein the substrate coating apparatus is configured to provide cleaning of the substrate.

39. A substrate coating apparatus as claimed in claim 37, wherein the resist coating apparatus is configured to simultaneous apply a resist coating on the upper side of the substrate and a monomolecular coating on the backside of the substrate.

40. A substrate coating apparatus as claimed in any of claims 33 to 36, wherein the gas flow provides thermal conditioning of the substrate.

41. A substrate coating apparatus as claimed in any of claims 27 to 35, wherein the substrate coating apparatus is a separate apparatus.

42. A substrate coating apparatus as claimed in claim 37 or 41, wherein the substrate coating apparatus is configured to simultaneously provide a monomolecular layer on a plurality of substrates.

43. A method for creating a monomolecular layer on a substrate, the method comprising bringing a vapor adjacent to the substrate.

44. A method as claimed in claim 43, wherein the creation of the monomolecular layer is combined with a cleaning step of the substrate.

45. A method as claimed in claim 43 or 44, wherein the creation of the monomolecular layer is combined with thermal conditioning of the substrate.

46. A method as claimed in claim 43 to 45, wherein the monomolecular layer is created while a measurement step of the substrate is performed.

47. A method as claimed in claim 46, wherein the monomolecular layer is created on the backside of the substrate while the upper side of the substrate is coated.

48. A method for removing a monomolecular layer from a substrate, the method comprising a step of exposing the substrate to a light source.

49. A method as claimed in claim 48, wherein the light source emits UV light.

50. A method as claimed in claim 48 or 49, wherein the light source forms part of a lithographic apparatus.

51. A metrology apparatus comprising a substrate as claimed in any of claims 1 to 13.

52. A lithographic apparatus comprising a substrate as claimed in any of claims 1 to 13.

53. A metrology apparatus comprising a substrate holder as claimed in any of claims 14 to 26.

54. A lithographic apparatus comprising a substrate holder as claimed in any of claims 14 to 26.

55. A metrology apparatus comprising a substrate coating apparatus as claimed in any of claims 27 to 40 or claim 42.

56. A lithographic apparatus comprising a substrate coating apparatus as claimed in any of claims 27 to 40 or claim 42.

57. A spin coating apparatus comprising a substrate coating apparatus as claimed in any of claims 27 to 40 or claim 42.
